# EUROPEAN PATENT APPLICATION

(11) **EP 4 269 105 A1**
(43) Date of publication of application: **01.11.2023**
(21) Application number: 21910309.0
(22) Date of filing: 08.12.2021
(51) Int. Cl.: B32B 27/34, C08G 73/10, C08L 79/08, H01L 21/683, C08K 3/013

(54) **RESIN COMPOSITION, SHEET-FORM COMPOSITION, SHEET CURED PRODUCT, LAMINATE, LAMINATE MEMBER, WAFER HOLDER, AND SEMICONDUCTOR MANUFACTURING DEVICE**

(30) Priority: 24.12.2020 JP 2020214586
(71) Applicant: Toray Industries, Inc., Tokyo 103-8666 (JP)
(72) Inventor: OKADA, Seidai, Otsu-shi, Shiga 520-8558 (JP); KIGUCHI, Kazuya, Otsu-shi, Shiga 520-8558 (JP); SHIMADA, Akira, Otsu-shi, Shiga 520-8558 (JP)
(74) Representative: Hoefer & Partner Patentanwälte mbB
(86) International application number: PCT/JP2021/045082
(87) International publication number: WO 2022/138160

(57) **Abstract**

The purpose of the present invention is to provide a resin composition which enables manufacturing an adhesive sheet for a electrostatic chuck which has excellent heat resistance, low elastic modulus, mitigates the substrate thermal expansion difference with a single layer, and is capable of adhesion and following. The resin composition contains a polymer (A) selected from polyimide and polyamic acid that have a diamine residue of a specific structure (below, the diamine residue (1)) and an acid anhydride residue of a specific structure (below, the acid anhydride residue (2)), and a thermosetting resin (B).

## Description

### TECHNICAL FIELD

The present invention relates to a resin composition containing a thermoplastic resin and a thermosetting resin, a sheet-form composition, a sheet cured product, a laminate, a laminate member, a wafer holder, and a semiconductor manufacturing device.

### BACKGROUND ART

In a wafer holder in which a ceramic electrostatic chuck (electrostatic chuck heater, susceptor) and a metal cooling plate are bonded to each other, resin adhesive tape or an adhesive material is generally used for bonding the electrostatic chuck and the cooling plate to each other. As an adhesive composition for such an application, an adhesive sheet for a semiconductor device containing a thermoplastic resin such as an acrylic copolymer and a thermosetting resin such as an epoxy resin has been proposed (Patent Document 1), but the operating temperature of such a conventional wafer holder is limited by the heat resistance of the resin (particularly the thermoplastic resin) (generally 100°C or lower, and at most 150°C or lower for those that can be used at a high temperature).

On the other hand, when a heat-resistant resin such as a polyimide is to be used, the elastic modulus of the resin is high, the difference in thermal expansion between the ceramic and the cooling plate cannot be absorbed, and deformation or cracking occurs, so that it is difficult to use the product as a wafer holder. In the case of bonding with a metal brazing material or the like, it can be used even at a high temperature as long as bonding is possible, or deformation or cracking occurs at the time of bonding unless the thermal expansion of the ceramic and the thermal expansion of the cooling plate (metal) are matched.

There has been proposed an adhesive sheet for an electrostatic chuck in which a silicone resin elastic phase capable of reducing thermal expansion is laminated on a polyimide-based adhesive agent layer having both heat resistance and adhesiveness in response to the above demand for closely adhering to and following a substrate by reducing thermal expansion of a ceramic and a cooling plate (metal) while having such heat resistance as to enable use at a high temperature such as 200°C (Patent Document 2).

### PRIOR ART DOCUMENT

### PATENT DOCUMENTS

Patent Document 1: Japanese Patent Laid-open Publication No. H11-265960
Patent Document 2: Japanese Patent Laid-open Publication No. 2002-83862

### SUMMARY OF THE INVENTION

### PROBLEMS TO BE SOLVED BY THE INVENTION

However, in the device of Patent Document 2, since the silicone elastic phase is more flexible than the adhesive agent layer and there is a difference in elastic modulus, there has been a possibility that peeling occurs between the silicone elastic phase and the adhesive agent layer. In addition, although the polyimide of the adhesive agent layer described in Patent Document 2 partially contains a flexible siloxane structure, the elastic modulus of the polyimide alone is still high, and it has been difficult to satisfy the demand for closely adhering to and following the substrate by reducing the thermal expansion difference while maintaining the heat resistance with the polyimide alone.

A main object of the present invention is to overcome the above shortcomings and to provide a resin composition that enables manufacturing an adhesive sheet for an electrostatic chuck that has excellent heat resistance and a low elastic modulus and reduces the thermal expansion difference of a substrate with a single layer to enable adhesion and following.

### SOLUTIONS TO THE PROBLEMS

In order to solve the above-mentioned problem, the present invention has the following configuration.

A resin composition containing a polymer (A) selected from a polyimide and a polyamic acid having a diamine residue represented by General Formula (1) (hereinafter referred to as a diamine residue (1)) and an acid anhydride residue represented by General Formula (2) (hereinafter referred to as an acid anhydride residue (2)), and a thermosetting resin (B).

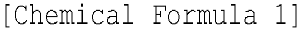

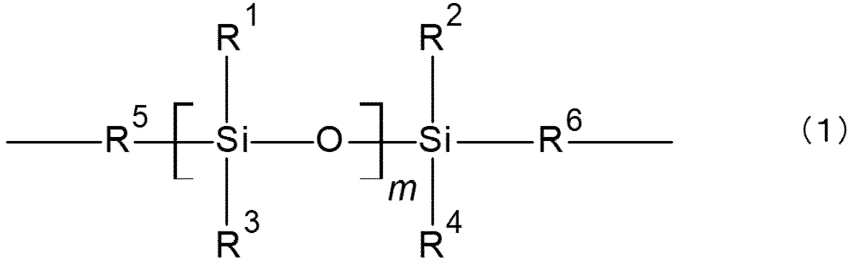

In General Formula (1), R¹ to R⁴ may be the same or different and each represent an alkyl group having 1 to 30 carbon atoms, a phenyl group, or a phenoxy group. The phenyl group and the phenoxy group may be substituted with an alkyl group having 1 to 30 carbon atoms. m R¹s and R³s may be the same or different.

In General Formula (1), R⁵ and R⁶ may be the same or different and each represent an alkylene group having 1 to 30 carbon atoms or an arylene group. The arylene group may be substituted with an alkyl group having 1 to 30 carbon atoms.

In General Formula (1), m is an integer selected from 1 to 100.

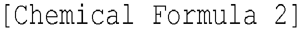

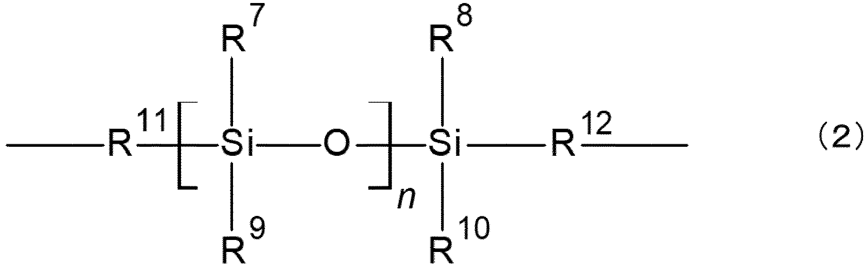

In General Formula (2), R⁷ to R¹⁰ may be the same or different and each represent an alkyl group having 1 to 30 carbon atoms, a phenyl group, or a phenoxy group. The phenyl group and the phenoxy group may be substituted with an alkyl group having 1 to 30 carbon atoms. n R⁷s and R⁹s may be the same or different.

In General Formula (2), R¹¹ and R¹² may be the same or different and each represent an alkylene group having 1 to 30 carbon atoms or an arylene group. The arylene group may be substituted with an alkyl group having 1 to 30 carbon atoms.

In General Formula (2), n is an integer selected from 1 to 100.

### EFFECTS OF THE INVENTION

With the resin composition of the present invention, it is possible to obtain an adhesive sheet for an electrostatic chuck that has excellent heat resistance and a low elastic modulus and satisfactorily maintains an adhesion state while reducing the difference in thermal expansion between a ceramic and a cooling plate (metal) even at a high temperature of 200°C or higher for a long period of time.

### EMBODIMENTS OF THE INVENTION

The present invention is a resin composition containing a polymer (A) selected from polyimides and polyamic acids having a diamine residue represented by General Formula (1) (hereinafter referred to as a diamine residue (1)) and an acid anhydride residue represented by General Formula (2) (hereinafter referred to as an acid anhydride residue (2)), and a thermosetting resin (B).

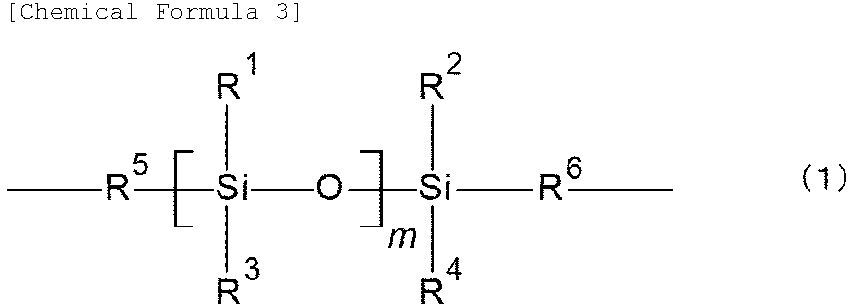

In General Formula (1), R¹ to R⁴ may be the same or different and each represent an alkyl group having 1 to 30 carbon atoms, a phenyl group, or a phenoxy group. The phenyl group and the phenoxy group may be substituted with an alkyl group having 1 to 30 carbon atoms. m R¹s and R³s may be the same or different.

In General Formula (1), R⁵ and R⁶ may be the same or different and each represent an alkylene group having 1 to 30 carbon atoms or an arylene group. The arylene group may be substituted with an alkyl group having 1 to 30 carbon atoms.

In General Formula (1), m is an integer selected from 1 to 100.

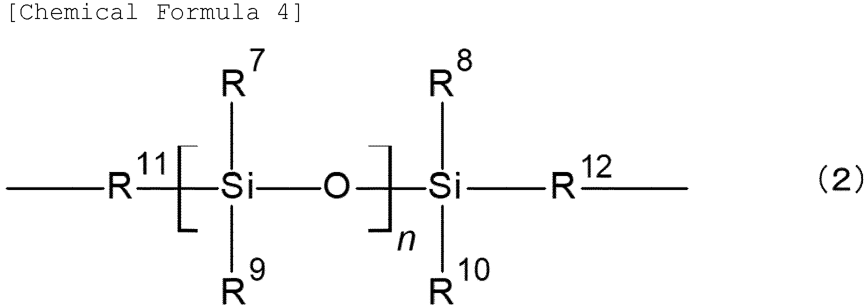

In General Formula (2), R⁷ to R¹⁰ may be the same or different and each represent an alkyl group having 1 to 30 carbon atoms, a phenyl group, or a phenoxy group. The phenyl group and the phenoxy group may be substituted with an alkyl group having 1 to 30 carbon atoms. n R⁷s and R⁹s may be the same or different.

In General Formula (2), R¹¹ and R¹² may be the same or different and each represent an alkylene group having 1 to 30 carbon atoms or an arylene group. The arylene group may be substituted with an alkyl group having 1 to 30 carbon atoms.

In General Formula (2), n is an integer selected from 1 to 100.

Hereinafter, an embodiment for carrying out the present invention will be described in detail. Incidentally, the present invention is not limited to the following embodiment. In the following embodiment, the components are not essential unless otherwise specified. The same applies to numerical values and ranges thereof, and the present invention is not limited thereto.

In the present specification, a numerical range indicated using "to" includes the numerical values described before and after "to" as the minimum value and the maximum value, respectively.

In the present specification, in the case where a plurality of substances corresponding to each component are present in the composition, the content of each component in the composition means the total content of the plurality of substances present in the composition unless otherwise specified. For example, in the case where the composition contains a component A and a component B as thermosetting resin components, the content of the thermosetting resin component means the sum of the contents of the component A and the component B.

In the present specification, when a region where a layer exists is observed, the term "layer" includes not only the case where the layer is formed in the entire region but also the case where the layer is formed only in a part of the region.

In the present specification, the term "laminating" refers to stacking of layers. Two or more layers may be bonded, or two or more layers may be detachable.

### <Resin Composition>

The resin composition of the present invention contains the polymer (A) selected from polyimides and polyamic acids having the diamine residue represented by General Formula (1) (hereinafter referred to as the diamine residue (1)) and the acid anhydride residue represented by General Formula (2) (hereinafter referred to as the acid anhydride residue (2)), and the thermosetting resin (B).

### <Polymer (A)>

The polymer (A) is selected from polyimides and polyamic acids having the diamine residue (1) and the acid anhydride residue (2). The polymer (A) is therefore generally obtained mainly by reacting a tetracarboxylic dianhydride and a diamine and has a tetracarboxylic dianhydride residue and a diamine residue.

The polymer (A) preferably contains 60 mol% or more and 100 mol% or less of the diamine residue (1) with the total content of diamine residues in the polymer (A) being 100 mol%. Containing the polymer (A) having a highly flexible siloxane skeleton makes it possible to improve the heat resistance of a sheet cured product obtained by curing the resin composition of the present invention and to reduce the elastic modulus, thereby providing a sheet cured product that is excellent in adhesion and follows the shape of the substrate. In the case where the content of the diamine residue (1) is less than 60 mol%, the elastic modulus of the sheet cured product is increased, and the adhesion and the followability to the substrate may be deteriorated. From the viewpoint of further reducing the elastic modulus and further improving the adhesion and followability to the substrate, when the total content of diamine residues in the polymer (A) is 100 mol%, the content of the diamine residue (1) is preferably 70 mol% or more and 100 mol% or less, more preferably 85 mol% or more and 100 mol% or less.

In General Formula (1), R¹ to R⁴ may be the same or different and each represent an alkyl group having 1 to 30 carbon atoms, a phenyl group, or a phenoxy group. The phenyl group and the phenoxy group may be substituted with an alkyl group having 1 to 30 carbon atoms. Here, the alkyl group may be linear or branched. Examples of the alkyl group having 1 to 30 carbon atoms include a methyl group, an ethyl group, a propyl group, and a butyl group. From the viewpoint of further improving the heat resistance, the carbon number of the alkyl group is preferably 12 or less. m R¹s and R³s may be the same or different.

In General Formula (1), R⁵ and R⁶ may be the same or different and each represent an alkylene group having 1 to 30 carbon atoms or an arylene group. The arylene group may be substituted with an alkyl group having 1 to 30 carbon atoms. In addition, both the alkylene group and the alkyl group may be linear or branched. Examples of the alkylene group having 1 to 30 carbon atoms include a methylene group, an ethylene group, a propylene group, and a butylene group. From the viewpoint of further improving the heat resistance, the carbon number of the arylene group is preferably 12 or less. Examples of the arylene group include a phenylene group. A group in which the alkylene group and the arylene group are bonded may be employed.

In General Formula (1), m represents the range of 1 or more and 100 or less. Although m is an integer in each polymer chain, the average obtained by the measurement of the whole polymer may not be an integer. From the viewpoint of further reducing the elastic modulus of the sheet cured product, m is preferably three or more, more preferably five or more. By setting m to five or more, the long and flexible siloxane chain can reduce the elastic modulus of the sheet cured product and improve the adhesion and followability to the substrate. Meanwhile, from the viewpoint of improving the compatibility with the thermosetting resin (B), m is preferably 40 or less. That is, in General Formula (1), m is preferably 3 or more and 40 or less.

The polymer (A) of the present invention preferably contains 50 mol% or more and 100 mol% or less of the acid anhydride residue (2) with the total content of acid anhydride residues in the polymer (A) being 100 mol%. Containing the polymer (A) having a highly flexible siloxane skeleton makes it possible to improve the heat resistance of a sheet cured product obtained by curing the resin composition of the present invention and to reduce the elastic modulus, thereby providing a sheet cured product that is excellent in adhesion and follows the shape of the substrate. In the case where the content of the acid anhydride residue (2) is less than 50 mol%, the elastic modulus of the sheet cured product is increased, and the adhesion and the followability to the substrate may be deteriorated. From the viewpoint of further reducing the elastic modulus and further improving the adhesion and followability to the substrate, when the total content of acid anhydride residues in the polymer (A) is 100 mol%, the content of the acid anhydride residue (2) is preferably 70 mol% or more and 100 mol% or less, more preferably 85 mol% or more and 100 mol% or less.

In General Formula (2), R⁷ to R¹⁰ may be the same or different and each represent an alkyl group having 1 to 30 carbon atoms, a phenyl group, or a phenoxy group. The phenyl group and the phenoxy group may be substituted with an alkyl group having 1 to 30 carbon atoms. The alkyl group may be linear or branched. Examples of the alkyl group having 1 to 30 carbon atoms include a methyl group, an ethyl group, a propyl group, and a butyl group. From the viewpoint of further improving the heat resistance, the carbon number of the alkyl group is preferably 12 or less. n R⁷s and R⁹s may be the same or different.

In General Formula (2), R¹¹ and R¹² may be the same or different and each represent an alkylene group having 1 to 30 carbon atoms or an arylene group. The arylene group may be substituted with an alkyl group having 1 to 30 carbon atoms. In addition, both the alkylene group and the alkyl group may be linear or branched. Examples of the alkylene group having 1 to 30 carbon atoms include a methylene group, an ethylene group, a propylene group, and a butylene group. From the viewpoint of further improving the heat resistance, the carbon number of the arylene group is preferably 12 or less. Examples of the arylene group include a phenylene group. A group in which the alkylene group and the arylene group are bonded may be employed.

In General Formula (2), n represents the range of 1 or more and 100 or less. Although n is an integer in each polymer chain, the average obtained by the measurement of the whole polymer may not be an integer. From the viewpoint of further reducing the elastic modulus of the sheet cured product, n is preferably three or more, more preferably five or more. By setting n to five or more, the long and flexible siloxane chain can reduce the elastic modulus of the sheet cured product and improve the adhesion and followability to the substrate. Meanwhile, from the viewpoint of improving the compatibility with the thermosetting resin (B), n is preferably 40 or less. That is, in General Formula (2), n is preferably 3 or more and 40 or less.

The polymer (A) of the present invention preferably contains a total of 55 mol% or more and 100 mol% or less of the diamine residue (1) and the acid anhydride residue (2) with the total content of all the diamine residues and all the acid anhydride residues in the polymer (A) being 100 mol%. Containing the polymer (A) having a highly flexible siloxane skeleton makes it possible to improve the heat resistance of a sheet cured product obtained by curing the resin composition of the present invention and to reduce the elastic modulus, thereby providing a sheet cured product that is excellent in adhesion and follows the shape of the substrate. In the case where the total content of the diamine residue (1) and the acid anhydride residue (2) is less than 55 mol%, the elastic modulus of the sheet cured product is increased, and the adhesion and the followability to the substrate may be deteriorated. From the viewpoint of further reducing the elastic modulus and further improving the adhesion and followability to the substrate, when the total content of all the diamine residues and all the acid anhydride residues in the polymer (A) is 100 mol%, the total content of the diamine residue (1) and the acid anhydride residue (2) is preferably 70 mol% or more and 100 mol% or less, more preferably 85 mol% or more and 100 mol% or less.

The glass transition temperature (Tg) of the polymer (A) is preferably -150°C or higher and -30°C or lower. By setting the Tg of the polymer (A) to -30°C or lower, the elastic modulus of the sheet cured product can be reduced in a wider temperature range. From the viewpoint of reducing the elastic modulus in a wider temperature range and expanding the usable temperature range to further improve versatility, the glass transition temperature (Tg) of the polymer (A) is more preferably -150°C or higher and -50°C or lower, still more preferably -150°C or higher and -80°C or lower. In order to set the Tg of the polymer (A) of the present invention to such a range, a method of controlling the structure of the polymer (A), particularly the ratio of the siloxane skeleton, can be mentioned.

The weight average molecular weight of the polymer (A) is preferably 1,000 or more, more preferably 10,000 or more. By setting the weight average molecular weight to 1,000 or more, the toughness of the sheet cured product can be improved, the elastic modulus can be reduced, and the heat resistance can be further improved because of the high molecular weight. Meanwhile, the weight average molecular weight of the polymer (A) is preferably 1,000,000 or less, more preferably 200,000 or less. By setting the weight average molecular weight to 1,000,000 or less, the viscosity in the form of a solution can be reduced, and the processability can be further improved.

The weight average molecular weight of the polymer (A) can be calculated in terms of polystyrene by subjecting a solution having a resin concentration of 0.1 wt% obtained by dissolving the polymer (A) in N-methyl-2-pyrrolidone to gel permeation chromatography (GPC) analysis.

The polymer (A) is preferably solvent-soluble. When the polymer is solvent-soluble, the viscosity during preparation of the resin composition can be lowered, and the dispersibility of an inorganic filler (C) can be further improved. "The polymer (A) is solvent-soluble" means that 1 g or more of the polymer (A) can be dissolved at 25°C in 100 g of any organic solvent selected from amide solvents such as N-methyl-2-pyrrolidone, N,N-dimethylacetamide, N,N-dimethylformamide, N-vinylpyrrolidone, and N,N-diethylformamide; γ-butyrolactone; and ether solvents such as monoglyme, diglyme, triglyme, methyl monoglyme, methyl diglyme, methyl triglyme, ethyl monoglyme, ethyl diglyme, ethylene glycol monomethyl ether, ethylene glycol monoethyl ether, propylene glycol monomethyl ether, propylene glycol monoethyl ether, ethylene glycol dimethyl ether, and ethylene glycol diethyl ether.

Examples of commercially available diamines preferably used as the raw material of the polymer (A) having a diamine residue represented by General Formula (1) above include X-22-161A, X-22-161B, KF8012, KF8010, KF8008, and X-22-1660B-3 manufactured by Shin-Etsu Chemical Co., Ltd. Two or more of these diamines may be used in combination.

The diamine residue that constitutes the polymer (A) preferably has a hydroxyl group and/or a carboxyl group. When the polymer has a diamine residue having a hydroxyl group or a carboxyl group, the reaction with the thermosetting resin (B) is promoted, and the toughness of the sheet cured product can be improved. From the viewpoint of improving the toughness of a thermally conductive sheet, the polymer preferably has 1 mol% or more of a diamine residue having a hydroxyl group and/or a carboxyl group in all diamine residues. Meanwhile, from the viewpoint of further reducing the elastic modulus of the sheet cured product and further improving the flexibility, the polymer preferably has 40 mol% or less, more preferably has 30 mol% or less of a diamine residue having a hydroxyl group and/or a carboxyl group in all diamine residues.

Examples of commercially available acid anhydrides preferably used as the raw material of the polymer (A) having an acid anhydride residue represented by General Formula (2) above include X-22-168AS, X-22-168A, X-22-168B, and X-22-168-P5-B manufactured by Shin-Etsu Chemical Co., Ltd. Two or more of these acid anhydrides may be used in combination.

### <Thermosetting Resin (B)>

The thermosetting resin (B) contained in the resin composition of the present invention is not particularly limited, but at least one selected from the group consisting of a polyimide resin, a bismaleimide resin, an epoxy resin, a phenol resin, a urethane resin, a silicone resin, an acrylic resin, and a poly(amide-imide) resin is preferably contained as the thermosetting resin (B). In particular, an epoxy resin can be preferably used from the viewpoint of excellent heat resistance and curing reactivity.

The content of the thermosetting resin (B) is not particularly limited, but the content is preferably 0.1 parts by weight or more based on 100 parts by weight of the polymer (A) from the viewpoint of improving the toughness and heat resistance at a high temperature of the resin composition and is preferably 15 parts by weight or less from the viewpoint of improving the flexibility of the composition.

### <Epoxy Resin>

The epoxy resin used as the thermosetting resin (B) of the present invention is not particularly limited but is preferably an epoxy resin containing an aromatic skeleton from the viewpoint of increasing the heat resistance at a high temperature of 200°C or higher and preventing the composition from weakening after long-time use at 200°C to increase adhesiveness. The aromatic skeleton is preferable because it is rigid. Examples of the aromatic skeleton include a benzene ring and a naphthalene ring. Examples of such an epoxy resin include jER 828 containing a bisphenol skeleton from Mitsubishi Chemical Corporation, jER 1032H60 containing a triphenylmethane skeleton, and EPICLON HP-4700 and EPICLON HP-4032SS having a naphthalene ring from DIC Corporation.

From the same viewpoint, an epoxy resin containing a triazine skeleton is also preferably used. Examples of such an epoxy resin include TEPIC-PAS B26L, TEPIC-PAS B22, TEPIC-S, TEPIC-VL, TEPIC-FL, and TEPIC-UC manufactured by Nissan Chemical Corporation.

In addition, an epoxy resin containing a siloxane skeleton is preferable from the viewpoint of reducing the elastic modulus of the composition after curing, improving the flexibility, and reducing the contact thermal resistance at the contact interface. Examples of such an epoxy resin include X-40-2695B and X-22-2046 manufactured by Shin-Etsu Chemical Co., Ltd.

From the same viewpoint and from the viewpoint of compatibility with the polymer (A), the inorganic filler (C), and a curing agent or curing accelerator (D), a flexible epoxy resin not containing a siloxane skeleton is more preferable. The flexible epoxy resin not containing a siloxane skeleton refers to an epoxy resin composed of an acyclic carbon compound, the carbon chain thereof may be linear or branched, and the bond may be a saturated bond or an unsaturated bond. Specifically, epoxy resins such as monoglycidyl etherified products of aliphatic alcohols, glycidyl esters of alkyl carboxylic acids, polyglycidyl etherified products of aliphatic polyhydric alcohols or alkylene oxide adducts thereof, and polyglycidyl esters of aliphatic long-chain polybasic acids are preferably used. Examples of the flexible epoxy resin not containing a siloxane skeleton include YX7400, YX7110, YX7180, and YX7105 manufactured by Mitsubishi Chemical Corporation.

The epoxy resin used in the present invention is preferably a crystalline epoxy resin from the viewpoint of improving thermal conductivity. The crystalline epoxy resin is an epoxy resin having a mesogen skeleton such as a biphenyl group, a naphthalene skeleton, an anthracene skeleton, a phenyl benzoate group, and a benzanilide group. Examples of such an epoxy resin include jER YX4000, jER YX4000H, jER YX8800, jER YL6121H, jER YL6640, jER YL6677, and jER YX7399 manufactured by Mitsubishi Chemical Corporation; NC3000, NC3000H, NC3000L, and CER-3000L manufactured by Nippon Kayaku Co., Ltd.; YSLV-80XY and YDC1312 manufactured by Nippon Steel Chemical Co., Ltd.; and HP4032, HP4032D, and HP4700 manufactured by DIC Corporation.

The epoxy resin used for the present invention is preferably an epoxy resin having a fluorene skeleton from the viewpoint of improving the dispersibility of the inorganic filler and improving the thermal conductivity. Examples of such an epoxy resin include PG100, CG500, CG300-M2, EG200, and EG250 manufactured by Osaka Gas Chemicals Co., Ltd.

In addition, the epoxy resin used in the present invention is preferably a glycidyl amine epoxy resin from the viewpoint of having high affinity with the polyimide, improving the crosslinking density with the polyimide, and improving the heat resistance. Examples of such an epoxy resin include jER 630, jER 630LSD, and jER 604 manufactured by Mitsubishi Chemical Corporation.

The epoxy resin used for the present invention is preferably a liquid epoxy resin from the viewpoint of reducing the viscosity when the inorganic filler is dispersed. The liquid epoxy resin here shows a viscosity of 150 Pa•s or less at 25°C and 1.013 × 10⁵ N/m², and examples thereof include a bisphenol A epoxy resin, a bisphenol F epoxy resin, an alkylene oxide modified epoxy resin, and a glycidyl amine epoxy resin. Examples of products corresponding to such an epoxy resin include jER 827, jER 828, jER 806, jER 807, jER 801N, jER 802, YX7400, jER 604, jER 630, and jER 630LSD manufactured by Mitsubishi Chemical Corporation; EPICLON 840S, EPICLON 850S, EPICLON 830S, EPICLON 705, and EPICLON 707 manufactured by DIC Corporation; YD-127, YD-128, PG-207N, and PG-202 manufactured by Nippon Steel Chemical Co., Ltd.; and TEPIC-PAS B26L, TEPIC-PAS B22, TEPIC-VL, TEPIC-FL, and TEPIC-UC manufactured by Nissan Chemical Corporation.

In the resin composition of the present invention, at least one selected from the group consisting of an epoxy resin containing an aromatic skeleton, a flexible epoxy resin not containing a siloxane skeleton, and a crystalline epoxy resin is particularly preferably used from the viewpoint of achieving both the stability of a coating material of the composition and the toughness and the heat resistance at a high temperature of the resin composition. From the viewpoint of the elastic modulus of the sheet cured product and the balance among other components in the resin composition, an epoxy resin containing an aromatic skeleton and a crystalline epoxy resin are preferably used in the case where high elasticity is to be achieved using the epoxy resin component, and a flexible epoxy resin not containing a siloxane skeleton is preferably used in the case where low elasticity is to be achieved using the epoxy resin component.

One type or a combination of two or more types of epoxy resins may be used in the present invention. The content of the epoxy resin is preferably 0.1 parts by weight or more based on 100 parts by weight of the polymer (A) from the viewpoint of improving the toughness and heat resistance at a high temperature of the composition and is preferably 15 parts by weight or less from the viewpoint of improving the flexibility of the composition.

### <Curing Agent or Curing Accelerator (D)>

The resin composition of the present invention may contain the curing agent or curing accelerator (D) as needed.

Curing of the thermosetting resin (B) such as an epoxy resin is promoted by combining a curing accelerator or a curing agent with the thermosetting resin (B) such as an epoxy resin, and the resin can be cured in a short time. As the curing agent or curing accelerator, an imidazole, a polyhydric phenol, an acid anhydride, an amine, a hydrazide, a polymercaptan, a Lewis acid-amine complex, or a latent curing agent can be used.

Examples of the imidazole include Curezol C17Z, Curezol 2MZ, Curezol 2PZ, Curezol 2MZ-A, and Curezol 2MZ-OK (trade names, manufactured by Shikoku Chemicals Corporation). Examples of the polyhydric phenol include SUMILITERESIN PR-HF3 and SUMILITERESIN PR-HF6 (trade names, manufactured by Sumitomo Bakelite Co., Ltd.); KAYAHARD KTG-105 and KAYAHARD NHN (trade names, manufactured by Nippon Kayaku Co., Ltd.); PHENOLITE TD2131, PHENOLITE TD2090, PHENOLITE VH-4150, PHENOLITE KH-6021, PHENOLITE KA-1160, and PHENOLITE KA-1165 (trade names, manufactured by DIC Corporation); and H-1 (manufactured by Meiwa Plastic Industries, Ltd.). Examples of the amine include aromatic amines SEIKACURE-S, BAPS, DPE/ODA, and Bis Amine A (trade names, Wakayama Seika Kogyo Co., Ltd.) and amines having a siloxane skeleton KF-8010 and X-22-161A (trade names, manufactured by Shin-Etsu Chemical Co., Ltd.). Examples of the latent curing agent include dicyandiamide latent curing agents, amine adduct latent curing agents, organic acid hydrazide latent curing agents, aromatic sulfonium salt latent curing agents, microcapsule latent curing agents, and photocurable latent curing agents.

Examples of the dicyandiamide latent curing agent include DICY7, DICY15, and DICY50 (trade names, manufactured by Japan Epoxy Resins Co., Ltd.); and AJICURE AH-154 and AJICURE AH-162 (trade names, manufactured by Ajinomoto Fine-Techno Co., Inc.). Examples of the amine adduct latent curing agent include AJICURE PN-23, AJICURE PN-40, AJICURE MY-24, and AJICURE MY-H (trade names, manufactured by Ajinomoto Fine-Techno Co., Inc.); and Fujicure FXR-1030 (trade name, manufactured by FUJI KASEI CO., LTD.). Examples of the organic acid hydrazide latent curing agent include AJICURE VDH and AJICURE UDH (trade names, manufactured by Ajinomoto Fine-Techno Co., Inc.). Examples of the aromatic sulfonium salt latent curing agent include SAN-AID SI100, SAN-AID SI150, and SAN-AID SI180 (trade names, manufactured by SANSHIN CHEMICAL INDUSTRY CO., LTD.). Examples of the microcapsule latent curing agent include those obtained by encapsulating each of the above curing agents with a vinyl compound, a urea compound, or a thermoplastic resin. Among these, examples of the microcapsule latent curing agent obtained by treating the amine adduct latent curing agent with an isocyanate include Novacure HX-3941HP, Novacure HXA3922HP, Novacure HXA3932HP, and Novacure HXA3042HP (trade names, manufactured by ASAHI KASEI CHEMICALS CORPORATION). Examples of the photocurable latent curing agent include OPTOMER SP and OPTOMER CP (manufactured by ADEKA CORPORATION).

In the case where the resin composition of the present invention contains the curing agent or curing accelerator (D), its content is preferably 0.1 parts by weight or more and 35 parts by weight or less relative to 100 parts by weight of the thermosetting resin (B).

### <Inorganic Filler (C)>

The resin composition of the present invention preferably contains the inorganic filler (C). The inorganic filler is not particularly limited as long as the properties of the adhesive are not impaired, and specific examples thereof include silica, aluminum oxide, silicon nitride, aluminum hydroxide, gold, silver, copper, iron, nickel, silicon carbide, aluminum nitride, titanium nitride, and titanium carbide. Among them, silica, aluminum oxide, silicon nitride, silicon carbide, and aluminum hydroxide are preferably used from the viewpoint of cost. Furthermore, silica and aluminum oxide are particularly preferably used from the viewpoint of the balance between cost and thermal conductivity. Here, silica may be either amorphous or crystalline and is not limited to use in different applications considering the characteristics of each. These inorganic fillers may be subjected to a surface treatment using a silane coupling agent or the like for the purpose of improving heat resistance, adhesiveness, and the like.

The shape of the inorganic filler is not particularly limited, and a crushed system, a spherical shape, a scale shape, or the like is used, but a spherical shape is preferably used from the viewpoint of dispersibility in a coating material. The particle size of the inorganic filler is not particularly limited, but from the viewpoint of reliability such as dispersibility, coatability, and thermal cyclability, an average particle size of 3 um or less and a maximum particle size of 10 um or less are used, an average particle size of 1 um or less and a maximum particle size of 6 um or less are preferably used, and an average particle size of 0.7 um or less and a maximum particle size of 2 um or less are more preferably used. The average particle size and the maximum particle size referred to herein were measured with a Horiba LA-500 laser diffraction particle size distribution analyzer. In order to improve reliability, the purity of the particles is more than 99%, preferably more than 99.8%, more preferably more than 99.9%. When the purity is 99% or less, a soft error of a semiconductor element is likely to occur due to α rays emitted from radioactive impurities such as uranium and thorium.

The content of the inorganic filler (C) is not particularly limited but is preferably 0 to 80 wt%, more preferably 0 to 70 wt%, even more preferably 2 to 60 wt% with the total amount of the resin composition of the present invention being 100 wt%.

### <Organic Solvent>

The resin composition of the present invention may further contain at least one organic solvent. When the resin composition contains an organic solvent, the resin composition can be adapted to various molding processes. As the organic solvent, one usually used for the resin composition can be used. Specific examples of the solvent include an alcohol solvent, an ether solvent, a ketone solvent, an amide solvent, an aromatic hydrocarbon solvent, an ester solvent, and a nitrile solvent. For example, methyl isobutyl ketone, dimethylacetamide, dimethylformamide, dimethyl sulfoxide, N-methyl-2-pyrrolidone, γ-butyrolactone, sulfolane, cyclohexanone, and methyl ethyl ketone can be used. One of these organic solvents may be used singly, or two or more of them may be used in combination.

### <Other Components>

The resin composition of the present invention may contain other components as necessary in addition to the above components. Examples of other components include a dispersant and a plasticizer. Examples of the dispersant include DISPERBYK (trade name) series ("DISPERBYK" is a registered trademark) manufactured by BYK Japan KK, AJISPER (trade name) series ("AJISPER" is a registered trademark) manufactured by Ajinomoto Fine-Techno Co., Ltd., HIPLAAD (trade name) series ("HIPLAAD" is a registered trademark) manufactured by Kusumoto Chemicals, Ltd., and Homogenol (trade name) series ("Homogenol" is a registered trademark) manufactured by Kao Corporation. One of these dispersants may be used singly, or two or more of them may be used in combination.

### <Sheet-Form Composition>

The sheet-form composition of the present invention is the resin composition in a sheet form obtained by forming the resin composition of the present invention into a sheet.

The sheet-form composition can be manufactured, for example, by applying the resin composition of the present invention on a support and removing at least a part of the solvent contained as necessary. In the case where the sheet-form composition is formed from the resin composition of the present invention, a sheet cured product having excellent flexibility and heat resistance can be obtained when the sheet-form composition is formed into a cured product.

The thickness of the sheet-form composition is not particularly limited but can be appropriately selected according to the purpose. For example, the thickness can be 50 um to 500 um and is preferably 80 um to 400 um from the viewpoint of thermal conductivity, electrical insulation, and flexibility.

The sheet-form composition of the present invention can be manufactured, for example, by applying a coating material (hereinafter also referred to as a "composition coating material") of a composition prepared by adding an organic solvent such as triethylene glycol dimethyl ether and cyclohexanone to the composition of the present invention on a support to form a coating layer (composition layer), then removing at least a part of the organic solvent from the coating layer, and drying the coating layer. Examples of the support include a polyethylene terephthalate (PET) film, a polyphenylene sulfide film, and a polyimide film. The joint surface of the support with the thermally conductive sheet may be subjected to a surface treatment with silicone, a silane coupling agent, an aluminum chelating agent, polyurea, or the like to improve adhesiveness to the sheet-form composition and peelability. The thickness of the support is preferably 10 to 200 um from the viewpoint of workability.

The application of the composition coating material can be performed by a known method. Specifically, the application can be performed by a method such as comma coating, die coating, lip coating, gravure coating, screen printing, and spray coating. Examples of the method for forming a composition layer having a predetermined thickness include a comma coating method in which an object to be coated is passed between gaps, and a die coating method in which a composition coating material at a controlled flow rate is applied from a nozzle. For example, in the case where the thickness of the coating layer (composition layer) before drying is 50 um to 500 µm, it is preferable to use a comma coating method or a lip coating method.

The drying method is not particularly limited as long as at least a part of the organic solvent contained in the composition coating material can be removed, and can be appropriately selected from commonly used drying methods according to the organic solvent contained in the composition coating material. In general, a method of heat treatment at about 80°C to 150°C can be mentioned.

In the case where the sheet-form composition (composition layer) of the present invention contains the thermosetting resin (B), the sheet-form composition (composition layer) means a state in which the curing reaction has partially proceeded from a state in which the curing reaction has not proceeded at all. For this reason, in particular, the sheet-form composition in a state in which the curing reaction has not proceeded at all has flexibility but has poor strength as a sheet. Therefore, in a state in which the support such as a PET film has been removed, self-supporting ability of the sheet is poor, and handling may be difficult.

Therefore, from the viewpoint of enhancing the handleability, it is preferable that the composition layer constituting the sheet-form composition be semi-cured. That is, the sheet-form composition is preferably a semi-cured composition that is a B-stage sheet obtained by further performing heat treatment until the composition layer is brought into a semi-cured state (B-stage state). Subjecting the composition layer to a semi-curing treatment can provide a sheet-form composition that is excellent in thermal conductivity and electrical insulation properties and is excellent in self-supporting ability and pot life as a B-stage sheet.

The conditions for heat-treating the sheet-form composition are not particularly limited as long as the composition layer can be brought into the B-stage state. The conditions can be appropriately selected according to the constitution of the composition. The heat treatment is preferably performed by a method selected from vacuum hot pressing, hot roll lamination, and the like in order to reduce voids in the composition layer formed when the composition coating material is applied. This makes it possible to efficiently manufacture the B-stage sheet having a flat surface.

Specifically, for example, the composition layer can be semi-cured to the B-stage state by heating and pressurizing the composition layer under reduced pressure (such as 1 kPa) at a temperature of 100°C to 200°C for 1 minute to 3 minutes at a press pressure of 1 MPa to 20 MPa.

It is preferable that the resin composition is applied onto supports, two sheets of the sheet-form composition in a dried state are bonded to each other, and then the product is semi-cured to the B-stage state by performing the heating and pressurizing treatment. At this time, it is desirable to bond the coating surfaces (the surfaces on which the composition layers are not in contact with the supports) of the composition layers to each other. When the composition layers are bonded to each other so as to be in contact with each other, both surfaces (that is, the surfaces appearing when the supports are peeled off) of the obtained sheet-form composition in the B-stage state become flatter, and adhesiveness to an adherend is improved. A heat dissipation component and an electronic component described later produced using such a sheet-form composition exhibit high thermal conductivity.

The thickness of the B-stage sheet can be appropriately selected according to the purpose. For example, the thickness can be 50 um to 500 um and is preferably 80 um to 300 um from the viewpoint of thermal conductivity, electrical insulation, and flexibility. It can also be produced by hot pressing while laminating two or more layers of the sheet-form composition.

The residual ratio of the volatile component in the B-stage sheet is preferably 2.0 mass% or less, more preferably 1.0 mass% or less, still more preferably 0.8 mass% or less from the viewpoint of suppressing bubble formation due to outgas generation when the composition layer is cured. The solvent residual ratio is determined from a mass change before and after drying by drying a sample obtained by cutting the B-stage sheet into 40 mm × 40 mm for 2 hours in a thermostatic chamber preheated to 190°C.

### <Sheet Cured Product>

The sheet cured product of the present invention is a product obtained by curing the resin composition or the sheet-form composition of the present invention, that is, a cured product thereof.

The sheet cured product can be manufactured by curing an uncured composition, a sheet-form composition, a B-stage composition, or a B-stage sheet-form composition. The method of the curing treatment can be appropriately selected according to the constitution of the composition, the purpose of the composition, and the like, but the heating and pressurizing treatment is preferable. For example, the heating temperature is preferably 120°C or higher, more preferably 150°C or higher, further preferably 180°C or higher. Meanwhile, the heating temperature is preferably 400°C or lower, more preferably 300°C or lower, further preferably 250°C or lower. The heating time is preferably 5 minutes to 5 hours. The heating temperature may be raised stepwise or may be continuously raised within a certain temperature range selected. Examples of the heating method include a method of heat-treating the sheet at 130°C and 200°C for 30 minutes each and a method of linearly raising the temperature from room temperature to 250°C over 2 hours. Examples of the heat treatment apparatus include an oven, a hot plate, and an infrared ray. In the case where the curing temperature is higher than 180°C, the sheet is preferably cured under a nitrogen atmosphere or under vacuum.

The sheet cured product of the present invention preferably has an elastic modulus of 0.1 to 100 MPa, more preferably 0.3 to 50 MPa, further preferably 0.5 to 15 MPa at 25°C. In order to set the elastic modulus of the sheet cured product of the present invention at 25°C to 0.5 to 15 MPa, the composition of the polymer (A), the thermosetting resin (B), the curing agent or curing accelerator (D), and the inorganic filler (C) in the composition may be appropriately adjusted, and in particular, a method of controlling the ratio of the siloxane skeleton in the polymer (A) may be mentioned.

The sheet cured product of the present invention preferably has an elastic modulus of 0.01 to 1,000 MPa, more preferably 0.1 to 90 MPa, further preferably 1 to 85 MPa at -70°C. In order to set the elastic modulus of the sheet cured product of the present invention at -70°C to 0.01 to 100 MPa, the composition of the polymer (A), the thermosetting resin (B), the curing agent or curing accelerator (D), and the inorganic filler (C) in the composition may be appropriately adjusted, and in particular, a method of controlling the ratio of the siloxane skeleton in the polymer (A) may be mentioned.

In the present invention, the elastic modulus of the sheet cured product is the value of the storage elastic modulus that is obtained by dynamic viscoelasticity measurement. Dynamic viscoelasticity is measured according to JIS K 7244 (1998) at a tensile mode. Examples of the dynamic viscoelasticity measuring apparatus include DMS6100 manufactured by Seiko Instruments Inc. and DVA-200 manufactured by IT Measurement Control Co., Ltd.

The glass transition temperature (Tg) of the sheet cured product of the present invention is preferably 0°C or lower, more preferably -20°C or lower, further preferably - 50°C or lower. The glass transition temperature (Tg) of the sheet cured product is preferably -120°C or higher. In order to set the glass transition temperature (Tg) of the sheet cured product to -120°C or higher and -50°C or lower, the composition of the polymer (A), the thermosetting resin (B), the curing agent or curing accelerator (D), and the inorganic filler (C) in the resin composition may be appropriately adjusted, and in particular, a method of controlling the ratio of the siloxane skeleton in the polymer (A) may be mentioned.

### <Laminate>

The laminate of the present invention is obtained by further laminating a resin sheet on the resin composition, the sheet-form composition, or the sheet cured product of the present invention. That is, the laminate of the present invention is a sheet including two or more layers including an adhesive layer and the resin composition, the sheet-form composition, or the sheet cured product of the present invention. The laminate of the present invention preferably includes an adhesive layer on at least a part of one side or both sides of the resin composition, the sheet-form composition, or the sheet cured product of the present invention. Here, the adhesive layer in the laminate may be in direct contact with the resin composition, the sheet-form composition, or the sheet cured product of the present invention, or a layer such as a metal layer may be present between the resin composition, the sheet-form composition, or the sheet cured product and the adhesive layer.

The type and material of the adhesive layer are not particularly limited, but the adhesive layer preferably contains at least one selected from the group consisting of an epoxy resin, a phenol resin, a urethane resin, a silicone resin, an acrylic resin, a polyimide resin, and a poly(amide-imide) resin, more preferably at least one selected from the group consisting of an epoxy resin, a urethane resin, an acrylic resin, and a polyimide resin from the viewpoint of adhesive strength.

The method for producing the laminate is not particularly limited, and for example, the laminate can be produced by a method selected from vacuum hot pressing, hot roll lamination, and the like.

### <Laminate Member>

The laminate member of the present invention is a laminate member including a member A, the sheet cured product of the present invention, and a member B in this order, in which the linear expansion coefficients of the member A and the member B are different by one or more.

The types and materials of the member A and the member B are not particularly limited as long as they are selected so that the linear expansion coefficients of the member A and the member B will be different by one or more, and examples of the member A and the member B include alumina, zirconia, aluminum nitride, silicon carbide, silicon nitride, glass, aluminum, copper, and titanium. The combination of the member A and the member B is not particularly limited as long as the combination is selected so that the linear expansion coefficients thereof will be different by one or more, but a combination of a ceramic and a metal is preferable. As a more specific combination of the member A and the member B, for example, alumina and aluminum, aluminum nitride and aluminum, alumina and titanium, silicon carbide and aluminum, and the like are preferable, and by selecting a combination of alumina and aluminum or a combination of aluminum nitride and aluminum, the linear expansion coefficients of the member A and the member B can be made different by one or more, which is particularly preferable.

### <Wafer Holder>

The wafer holder of the present invention includes the laminate member of the present invention. More specifically, the wafer holder of the present invention includes a laminate member including the sheet cured product of the present invention between a ceramic coulomb force type electrostatic chuck, which is the member A, having a function of adsorbing and holding an object to be adsorbed and a metal cooling plate, which is the member B. The wafer holder of the present invention has a temperature adjusting function and preferably has a function of uniformly and constantly adjusting the temperature of the object to be adsorbed. Since the wafer holder is used in a wide temperature range from a low temperature of 0°C or lower to a high temperature of 150°C or higher, it is required that the electrostatic chuck and the cooling plate are not separated even when a cooling/heating cycle is repeated. By providing the sheet cured product of the present invention therebetween, the thermal stress in the cooling/heating cycle can be relaxed, and the adhesion state can be favorably maintained over a wide temperature range and a long period of time. In particular, by providing the sheet cured product of the present invention, the adhesion state can be favorably maintained from a low temperature range of 0°C or lower to a high temperature range of 200°C or higher.

### <Semiconductor Manufacturing Device>

The semiconductor manufacturing device of the present invention includes the wafer holder of the present invention. Therefore, the semiconductor manufacturing device of the present invention preferably includes a plasma source and a wafer holder having a temperature adjusting mechanism. In the semiconductor manufacturing device, a dry etching step is performed on a substrate to be processed as follows: the substrate to be processed such as a semiconductor wafer is placed on the wafer holder provided in a processing chamber, and a high frequency voltage is applied to the processing chamber under a vacuum environment to generate plasma. Since the processing accuracy required for the dry etching step is increasing, to increase the uniformity of the plasma processing in the surface of the substrate to be processed, the temperature of the substrate to be processed is adjusted to be constant. As described above, by providing the sheet cured product of the present invention, the adhesion state can be favorably maintained over a wide temperature range and a long period of time, and as a result, the uniformity of the plasma treatment in the surface of the substrate to be treated can be favorably maintained.

### EXAMPLES

Hereinafter, the present invention will be specifically described with reference to Examples, but the present invention is not limited thereto. First, evaluation methods performed in Examples 1 to 17 and Comparative Examples 1 and 2 will be described.

### <Production of Evaluation Sample>

A sheet-form composition produced in each of Examples and Comparative Examples described later was cut into 50 mm square, one protective film of an adhesive agent sheet having an adhesive agent layer with a thickness of 50 um was further peeled off, and the adhesive agent layers were laminated to each other under the conditions of 120°C and 0.4 MPa to perform lamination. This procedure was repeated to form an adhesive agent layer having a thickness of 200 µm, and then the product was heated and cured at 180°C for 6 hours to provide a sheet cured product sample for evaluation.

(1) Elastic Modulus at 25°C:
   The sheet cured product sample for evaluation was cut into a size of 5 mm × 20 mm to produce a sheet cured product sample for evaluation of the elastic modulus at 25°C.

The elastic modulus of the sample for evaluation of the elastic modulus at 25°C was measured with a dynamic viscoelasticity measuring apparatus DMS6100 manufactured by Seiko Instruments Inc. The storage elastic modulus at each temperature in the range from -130°C to 300°C was measured under the measurement conditions of a temperature rise rate of 5°C/min and a measurement frequency of 1 Hz, and the value of the storage elastic modulus at 25°C was taken as the elastic modulus at 25°C.

### (2) Glass Transition Temperature (Tg)

Using the sheet cured product sample for evaluation cut into 5 mm × 20 mm, dynamic viscoelasticity measurement was performed to determine the glass transition temperature (Tg). The measurement was performed using a dynamic viscoelasticity measuring apparatus DMS6100 manufactured by Seiko Instruments Inc. at temperatures of -70 to 300°C, a temperature rise rate of 5°C/min, a tensile mode, and a frequency of 1 Hz. The temperature of the peak value of tan δ of the obtained curve was defined as Tg.

### (3) Shear Strain

A sheet-form composition described later was cut into 10 mm × 10 mm, and a PET film on one side was peeled off, and then the sheet composition was attached to an aluminum plate having a length of 50 mm × a width of 15 mm × a thickness of 0.5 mm. Further, a PET film on the other side was peeled off, and the surface was attached to another aluminum plate in a shifted state to produce a test piece for a shear test.

The test piece for the shear test was heated and cured at 180°C for 6 hours and then subjected to a tensile test with a tensile and compression testing machine Technograph TG-1kN manufactured by MinebeaMitsumi Inc., and the displacement at the breaking point was measured. The measurement was carried out at a load cell of 1 kN and a pulling rate of 5 mm/min. The value obtained by dividing the displacement at the breaking point by the thickness of the sheet-form composition was taken as the shear strain.

### (4) Heat Resistance

The test piece for the shear test obtained by the above method was heated and cured at 180°C for 6 hours and further heated at 250°C for 1,000 hours under vacuum, and the test piece was subjected to a tensile test with a tensile and compression testing machine Technograph TG-1kN manufactured by MinebeaMitsumi Inc. to calculate the shear strain. The measurement was carried out at a load cell of 1 kN and a pulling rate of 5 mm/min. A sample in which the change rate between the shear strain after heat curing at 180°C for 6 hours and the shear strain after further heating under vacuum at 250°C for 1,000 hours was less than 30% was rated as "good", and a sample in which the change rate was 30% or more was rated as "poor".

### (5) Imidization Rate of Synthesized Polymer (A)

First, the infrared absorption spectrum of the polymer (A) was measured to confirm the presence of absorption peaks (near 1780 cm⁻¹ and near 1377 cm⁻¹) of the imide structure attributed to the polyimide. Next, the polymer (A) was subjected to a heat treatment at 350°C for 1 hour, an infrared spectrum was measured again, and then peak intensities near 1,377 cm⁻¹ before the heat treatment and after the heat treatment were compared. Assuming that the imidization rate of the polymer (A) after the heat treatment was 100%, the imidization rate of the polymer (A) before the heat treatment was determined.

### (6) Glass Transition Temperature (Tg) of Synthesized Polymer (A)

After removing the solvent of the polymer (A), differential scanning calorimetry was performed to determine the glass transition temperature (Tg). The measurement was performed using a differential scanning calorimeter DSC6200 manufactured by Seiko Instruments Inc. at temperatures of -150 to 300°C and a temperature rise rate of 10°C/min. The onset temperature of the obtained DSC curve was defined as the Tg of the polymer (A).

### (7) Weight Average Molecular Weight of Synthesized Polymer (A)

A solution having a polyimide concentration of 0.1 wt% obtained by dissolving the polymer (A) obtained by the method described in each of Examples and Comparative Examples in N-methyl-2-pyrrolidone (hereinafter referred to as NMP) was subjected to measurement as a measurement sample using a GPC apparatus Waters 2690 (manufactured by Waters Corporation) having the following structure to calculate the weight average molecular weight in terms of polystyrene.

The GPC measurement conditions were as follows: a moving bed was NMP in which LiCl and phosphoric acid were dissolved at concentrations of 0.05 mol/L each, and the development rate was 0.4 ml/min.
Detector: Waters 996
System controller: Waters 2690
Column oven: Waters HTR-B
Thermocontroller: Waters TCM
Column: TOSOH guard column (placed to capture coarse particles mixed in the object to be measured and prevent clogging of the column)
Column: TOSOH TSK-GEL α-4000 (a column with an exclusion limit molecular weight of 1,000,000)
Column: TOSOH TSK-GEL α-2500 (a column with an exclusion limit molecular weight of 10,000)
These three columns were connected in series in this order.

The details of the raw materials indicated by abbreviations in each Example are shown below.
<Resin>
   - The polymer (A) selected from polyimides and polyamic acids
<Raw Material of Polymer (A)>
   X-22-168 AS: (manufactured by Shin-Etsu Chemical Co., Ltd.) (number average molecular weight: 1,000, both-end acid-anhydride-modified polysiloxane of General Formula (2), n = 9) (R⁷ to R¹⁰ are methyl groups)
   X-22-168 A: (manufactured by Shin-Etsu Chemical Co., Ltd.) (number average molecular weight: 2,000, both-end acid-anhydride-modified polysiloxane of General Formula (2), n = 19) (R⁷ to R¹⁰ are methyl groups)
   ODPA: 4,4'-oxydiphthalic dianhydride (manufactured by Manac Incorporated)
   BPDA: 3,3'-4,4'-biphenyltetracarboxylic dianhydride (manufactured by Mitsubishi Chemical Corporation)
   KF 8010: diaminopolysiloxane (manufactured by Shin-Etsu Chemical Co., Ltd.) (number average molecular weight: 860, diaminopolysiloxane of General Formula (1), m = 9) (R¹ to R⁴ are methyl groups, and R⁵ and R⁶ are trimethylene groups)
   X-22-161 A: diaminopolysiloxane (manufactured by Shin-Etsu Chemical Co., Ltd.) (number average molecular weight: 1,600, diaminopolysiloxane of General Formula (1), m = 19) (R¹ to R⁴ are methyl groups, and R⁵ and R⁶ are trimethylene groups)
   BAHF: 2,2-bis(3-amino-4-hydroxyphenyl)hexafluoroisopropylidene (manufactured by Tokyo Chemical Industry Co., Ltd.).

### <Synthesis of Polymer (A)>

### • Polymer (A) A

A stirrer, a thermometer, a nitrogen introducing tube, and a dropping funnel were installed on a 500-ml four-necked flask, and 47.27 g of triethylene glycol dimethyl ether and 108.00 g of X-22-168AS were charged thereto under a nitrogen atmosphere and stirred and dissolved at 60°C. Thereafter, while stirring at 120°C, 3.66 g of BAHF and 77.40 g of KF8010 were added thereto, and the mixture was stirred for 1 hour. Thereafter, the mixture was heated to 200°C, stirred for 3 hours, and then cooled to room temperature to provide a polymer (A) A (solid content concentration: 80.0 wt%). The weight average molecular weight of the polymer (A) A was measured and found to be 45,600, and the imidization rate was measured and found to be 99%.

### • Polymer (A) B

A stirrer, a thermometer, a nitrogen introducing tube, and a dropping funnel were installed on a 500-ml four-necked flask, and 102.24 g of dimethylacetamide, 98.00 g of X-22-168AS, and 7.45 g of ODPA were charged thereto under a nitrogen atmosphere and stirred and dissolved at 60°C. Thereafter, while stirring at 120°C, 4.40 g of BAHF and 89.64 g of KF8010 were added thereto, and the mixture was stirred for 1 hour. Thereafter, the mixture was heated to 200°C, stirred for 3 hours, and then cooled to room temperature to provide a polymer (A) B (solid content concentration: 60.0 wt%). The weight average molecular weight of the polymer (A) B was measured and found to be 57,320, and the imidization rate was measured and found to be 99%.

### • Polymer (A) C

A stirrer, a thermometer, a nitrogen introducing tube, and a dropping funnel were installed on a 500-ml four-necked flask, and 113.92 g of dimethylacetamide, 77.25 g of X-22-168AS, and 23.27 g of ODPA were charged thereto under a nitrogen atmosphere and stirred and dissolved at 60°C. Thereafter, while stirring at 120°C, 5.49 g of BAHF and 112.05 g of KF8010 were added thereto, and the mixture was stirred for 1 hour. Thereafter, the mixture was heated to 200°C, stirred for 3 hours, and then cooled to room temperature to provide a polymer (A) C (solid content concentration: 60.0 wt%). The weight average molecular weight of the polymer (A) C was measured and found to be 69,750, and the imidization rate was measured and found to be 99%.

### • Polymer (A) D

A stirrer, a thermometer, a nitrogen introducing tube, and a dropping funnel were installed on a 500-ml four-necked flask, and 92.93 g of triethylene glycol dimethyl ether and 86.40 g of X-22-168AS were charged thereto under a nitrogen atmosphere and stirred and dissolved at 60°C. Thereafter, while stirring at 120°C, 11.72 g of BAHF and 41.28 g of KF8010 were added thereto, and the mixture was stirred for 1 hour. Thereafter, the mixture was heated to 200°C, stirred for 3 hours, and then cooled to room temperature to provide a polymer (A) D (solid content concentration: 80.0 wt%). The weight average molecular weight of the polymer (A) D was measured and found to be 60,350, and the imidization rate was measured and found to be 99%.

### • Polymer (A) E

A stirrer, a thermometer, a nitrogen introducing tube, and a dropping funnel were installed on a 500-ml four-necked flask, and 132.70 g of triethylene glycol dimethyl ether and 121.00 g of X-22-168A were charged thereto under a nitrogen atmosphere and stirred and dissolved at 60°C. Thereafter, while stirring at 120°C, 2.01 g of BAHF and 76.23 g of X-22-161A were added thereto, and the mixture was stirred for 1 hour. Thereafter, the mixture was heated to 200°C, stirred for 3 hours, and then cooled to room temperature to provide a polymer (A) E (solid content concentration: 60.0 wt%). The weight average molecular weight of the polymer (A) E was measured and found to be 48,020, and the imidization rate was measured and found to be 99%.

### • Polymer (A) F

A stirrer, a thermometer, a nitrogen introducing tube, and a dropping funnel were installed on a 500-ml four-necked flask, and 39.86 g of triethylene glycol dimethyl ether and 108.00 g of X-22-168AS were charged thereto under a nitrogen atmosphere and stirred and dissolved at 60°C. Thereafter, while stirring at 120°C, 25.64 g of BAHF and 25.80 g of KF8010 were added thereto, and the mixture was stirred for 1 hour. Thereafter, the mixture was heated to 200°C, stirred for 3 hours, and then cooled to room temperature to provide a polymer (A) F (solid content concentration: 80.0 wt%). The weight average molecular weight of the polymer (A) F was measured and found to be 55,680, and the imidization rate was measured and found to be 99%.

### • Polymer (A) G

A stirrer, a thermometer, a nitrogen introducing tube, and a dropping funnel were installed on a 500-ml four-necked flask, and 33.79 g of triethylene glycol dimethyl ether, 32.40 g of X-22-168AS, and 21.72 g of ODPA were charged thereto under a nitrogen atmosphere and stirred and dissolved at 60°C. Thereafter, while stirring at 120°C, 3.66 g of BAHF and 77.40 g of KF8010 were added thereto, and the mixture was stirred for 1 hour. Thereafter, the mixture was heated to 200°C, stirred for 3 hours, and then cooled to room temperature to provide a polymer (A) G (solid content concentration: 80.0 wt%). The weight average molecular weight of the polymer (A) G was measured and found to be 59,790, and the imidization rate was measured and found to be 99%.

### • Polymer (A) H

A stirrer, a thermometer, a nitrogen introducing tube, and a dropping funnel were installed on a 300-ml four-necked flask, and 88.39 g of triglyme and 14.56 g of BPDA were charged thereto under a nitrogen atmosphere and stirred and dissolved at 60°C. Thereafter, while stirring at 120°C, 1.83 g of BAHF and 72.00 g of X-22-161A were added thereto, and the mixture was further stirred for 1 hour. Thereafter, the mixture was heated to 200°C, stirred for 3 hours, and then cooled to room temperature to provide a polymer (A) F (solid content concentration: 50.0 wt%). The weight average molecular weight of the polymer (A) F was measured and found to be 45,300, and the imidization rate was measured and found to be 99%.

### • Polymer (A) I

A stirrer, a thermometer, a nitrogen introducing tube, and a dropping funnel were installed on a 500-ml four-necked flask, and 77.13 g of triethylene glycol dimethyl ether and 86.40 g of X-22-168AS were charged thereto under a nitrogen atmosphere and stirred and dissolved at 60°C. Thereafter, while stirring at 120°C, 29.30 g of BAHF was added thereto, and the mixture was stirred for 1 hour. Thereafter, the mixture was heated to 200°C, stirred for 3 hours, and then cooled to room temperature to provide a polymer (A) G (solid content concentration: 80.0 wt%). The weight average molecular weight of the polymer (A) G was measured and found to be 74,270, and the imidization rate was measured and found to be 99%.

The monomer components and properties of the synthesized polymers (A) are shown in Tables 1 and 2.

- Acrylic Rubber: epoxy group-containing acrylic rubber having a weight average molecular weight of 850,000, Tg: -32°C, monomer copolymerization ratio: ethyl acrylate : butyl acrylate : glycidyl acrylate = 65 : 35 : 1, functional group (epoxy group) content: 0.09 eq/kg.

### • Aromatic Polyimide

### <Synthesis of Aromatic Polyimide>

Under a dry nitrogen stream, 24.54 g (0.067 mol) of BAHF, 4.97 g (0.02 mol) of 1,3-bis(3-aminopropyl)tetramethyldisiloxane, and 2.18 g (0.02 mol) of 3-aminophenol as an end-capping agent were dissolved in 80 g of N-methylpyrrolidone (hereinafter referred to as NMP). To this solution, 31.02 g (0.1 mol) of ODPA was added together with 20 g of NMP, and the solution was allowed to react for 1 hour at 20°C and then stirred for 4 hours at 50°C. Subsequently, 15 g of xylene was added to the reaction solution, and the resultant mixture was stirred at 180°C for 5 hours while azeotropically boiling water together with xylene. After the completion of the stirring, the solution was introduced into 3 L of water to produce a polymer as a white precipitate. This precipitate was collected by filtration, washed 3 times with water, and then dried with a vacuum dryer at 80°C for 20 hours. The infrared absorption spectrum of the resulting polymer solid was measured, and absorption peaks corresponding to imide structures derived from the polyimide were detected around 1780 cm⁻¹ and 1377 cm⁻¹. In this manner, an aromatic polyimide that had a functional group capable of reacting with an epoxy group was obtained.
- Thermosetting Resin (B)
   jER 1032 H 60: tris(hydroxyphenyl)methane epoxy resin (manufactured by Mitsubishi Chemical Corporation)
   HP 4700: naphthalene type polyfunctional epoxy resin (manufactured by DIC Corporation).
- Inorganic Filler (C)
   AA-3: high-purity alumina (average particle size: 3 µm) (manufactured by Sumitomo Chemical Co., Ltd.)
   AA-04: high-purity alumina (average particle size: 0.4 µm) (manufactured by Sumitomo Chemical Co., Ltd.)
   SO-E1: high-purity synthetic spherical silica (average particle size: 0.3 µm) (manufactured by Admatechs Co., Ltd.).
- Curing Agent or Curing Accelerator (D)
   SEIKACURE-S: 4,4-diaminodiphenylsulfone (manufactured by Wakayama Seika Kogyo Co., Ltd.)
   C17Z: 2-heptadecylimidazole (manufactured by Shikoku Chemicals Corporation)

### <Examples 1 to 17 and Comparative Examples 1 to 4>

In each of Examples 1 to 17 and Comparative Examples 1 to 4, blending was performed so as to achieve the composition shown in Tables 3 to 5, triethylene glycol dimethyl ether was added thereto, and the mixture was stirred with a rotation-revolution mixer (manufactured by Thinky Corporation) at 1,800 rpm for 10 minutes to prepare a composition solution.

The composition solution was applied to a 38 µm-thick polyethylene terephthalate film (RF2 • PETcs000 manufactured by I'm Corporation) with a silicone release agent using a bar coater so as to have a dry thickness of 50 um (hereinafter referred to as a composition coating film). The product was dried at 120°C for 30 minutes, and the protective film was bonded at 120°C and 0.4 MPa to produce a sheet-form composition. The results of various evaluations subsequently performed are shown in Tables 3 to 5.

**[Table 1]**

| Item | | Polymer A | Polymer B | Polymer C | Polymer D | Polymer E |
|---|---|---|---|---|---|---|
| Tetracarboxylic acid dianhydride (mol%) | X-22-168AS | 100 | 80 | 50 | 100 | - |
| | X-22-168A | - | - | - | - | 100 |
| | ODPA | - | 20 | 50 | - | - |
| | BPDA | - | - | - | - | - |
| Diamine (mol%) | KF8010 | 90 | 90 | 90 | 60 | - |
| | X-22-161A | - | - | - | - | 90 |
| | BAHF | 10 | 10 | 10 | 40 | 10 |
| Properties | Imidization rate (%) | 99 | 99 | 99 | 99 | 99 |
| | Tg(°C) | -95 | -75 | -36 | -65 | -120 |
| | Weight average molecular weight | 45600 | 57320 | 69750 | 60350 | 48020 |

**[Table 2]**

| Item | | Polymer F | Polymer G | Polymer H | Polymer I |
|---|---|---|---|---|---|
| Tetracarboxylic acid dianhydride (mol%) | X-22-168AS | 100 | 30 | - | 100 |
| | X-22-168A | - | - | - | - |
| | ODPA | - | 70 | - | - |
| | BPDA | - | - | 100 | - |
| Diamine (mol%) | KF8010 | 30 | 90 | - | - |
| | X-22-161A | - | - | 90 | - |
| | BAHF | 70 | 10 | 10 | 100 |
| Properties | Imidization rate (%) | 99 | 99 | 99 | 99 |
| | Tg(°C) | -51 | -48 | -30 | -30 |
| | Weight average molecular weight | 55680 | 59790 | 45300 | 74270 |

**[Table 3]**

| Item | | Example 1 | Example 2 | Example 3 | Example 4 | Example 5 | Example 6 | Example 7 |
|---|---|---|---|---|---|---|---|---|
| Thermoplastic resin (in terms of solid content) (g) | Polymer A | 8.08 | 8.08 | - | - | - | - | 8.08 |
| | Polymer B | - | - | 8.08 | - | - | - | - |
| | Polymer C | - | - | - | 8.08 | - | - | - |
| | Polymer D | - | - | - | - | 8.08 | - | - |
| | Polymer E | - | - | - | - | - | 8.08 | - |
| | Polymer F | - | - | - | - | - | - | - |
| | Polymer G | - | - | - | - | - | - | - |
| | Polymer H | - | - | - | - | - | - | - |
| | Polymer I | - | - | - | - | - | - | - |
| | Acrylic rubber | - | - | - | - | - | - | - |
| | Aromatic polyimide | | | | | | | |
| Thermosetting resin (g) | jER1032H60 | - | - | - | - | - | - | 0.91 |
| | HP4700 | 0.9 | 0.9 | 0.9 | 0.9 | 0.9 | 0.9 | - |
| Inorganic filler (g) | AA-3 | - | 22.4 | 22.4 | 22.4 | 22.4 | 22.4 | 22.4 |
| | AA-04 | - | 2.8 | 2.8 | 2.8 | 2.8 | 2.8 | 2.8 |
| | SO-E1 | - | - | - | - | - | - | - |
| Curing agent (g) | SEIKACURE-S | 0.34 | 0.34 | 0.34 | 0.34 | 0.34 | 0.34 | 0.33 |
| | C17Z | - | - | - | - | - | - | - |
| Evaluation result | Elastic modulus (MPa) | 3.7 | 11 | 14 | 35 | 36 | 6.4 | 11 |
| | Tg(°C) | -69.6 | -63.6 | -51.8 | -12.4 | -31.6 | -67.2 | -61.6 |
| | Shear strain | 3.47 | 2.07 | 1.88 | 1.95 | 1.78 | 2.35 | 2.04 |
| | Heat resistance | Good | Good | Good | Good | Good | Good | Good |

**[Table 4]**

| Item | | Example 8 | Example 9 | Example 10 | Example 11 | Example 12 | Example 13 | Example 14 |
|---|---|---|---|---|---|---|---|---|
| Thermoplastic resin (in terms of solid content) (g) | Polymer A | 8.08 | 8.08 | 8.08 | 8.08 | 8.08 | 8.08 | - |
| | Polymer B | - | - | - | - | - | - | - |
| | Polymer C | - | - | - | - | - | - | - |
| | Polymer D | - | - | - | - | - | - | 8.08 |
| | Polymer E | - | - | - | - | - | - | - |
| | Polymer F | - | - | - | - | - | - | - |
| | Polymer G | - | - | - | - | - | - | - |
| | Polymer H | - | - | - | - | - | - | - |
| | Polymer I | - | - | - | - | - | - | - |
| | Acrylic rubber | - | - | - | - | - | - | - |
| | Aromatic polyimide | | | | | | | |
| Thermosetting resin (g) | jER1032H60 | 0.91 | 0.91 | 1.24 | 1.24 | 1.24 | 1.24 | 1.24 |
| | HP4700 | - | - | - | - | - | - | |
| Inorganic filler (g) | AA-3 | 11.9 | 4.9 | 22.4 | 11.9 | 4.9 | - | - |
| | AA-04 | 1.49 | 0.61 | 2.8 | 1.49 | 0.61 | - | - |
| | SO-E1 | - | - | - | - | - | 3.08 | 3.08 |
| Curing agent (g) | SEIKACURE-S | 0.33 | 0.33 | - | - | - | - | - |
| | C17Z | - | - | 0.062 | 0.062 | 0.062 | 0.036 | 0.036 |
| Evaluation result | Elastic modulus (MPa) | 4.3 | 1.6 | 43 | 23 | 11 | 6.6 | 36 |
| | Tg(°C) | -64.8 | -66.7 | -64.7 | -64.9 | -68.6 | -69.4 | -32.1 |
| | Shear strain | 2.84 | 3.49 | 2.36 | 2.15 | 2.03 | 3.14 | 2.41 |
| | Heat resistance | Good | Good | Good | Good | Good | Good | Good |

**[Table 5]**

| Item | | Example 15 | Example 16 | Example 17 | Comparative Example 1 | Comparative Example 2 | Comparative Example 3 | Comparative Example 4 |
|---|---|---|---|---|---|---|---|---|
| Thermoplastic resin (in terms of solid content) (g) | Polymer A | 8 .08 | - | - | - | - | - | - |
| | Polymer B | - | - | - | - | - | - | - |
| | Polymer C | - | - | - | - | - | - | - |
| | Polymer D | - | - | - | - | - | - | - |
| | Polymer E | - | - | - | - | - | - | - |
| | Polymer F | - | 8.08 | - | - | - | - | - |
| | Polymer G | - | - | 8.08 | - | - | - | - |
| | Polymer H | - | - | - | - | - | 8.08 | - |
| | Polymer I | - | - | - | - | - | - | 8.08 |
| | Acrylic rubber | - | - | - | 8.08 | - | | - |
| | Aromatic polyimide | - | - | - | - | 8.08 | | |
| Thermosetting resin (g) | jER1032H60 | 1.24 | - | - | - | - | - | - |
| | HP4700 | - | 0.9 | 0.9 | 0.9 | 0.9 | 0.9 | 0.9 |
| Inorganic filler (g) | AA-03 | - - | - - | - - | - - | - - | - - | - - |
| | AA-04 SO-E1 | - | - | - | - | - | - | - |
| | | | | | | | | |
| Curing agent (g) | SEIKACURE-S | - | 0.34 | 0.34 | 0.34 | 0.34 | 0.34 | 0.34 |
| | C17Z | 0.036 | - | - | - | - | - | - |
| Evaluation result | Elastic modulus (MPa) | 0.7 | 64 | 72 | 3.3 | 4500 | 110 | 120 |
| | Tg(°C) | -72.1 | -26.8 | -24.1 | -28.5 | 315 | -11.4 | -10.9 |
| | Shear strain | 4.21 | 1.68 | 1.56 | 4.12 | 0.31 | 1.14 | 1.02 |
| | Heat resistance | Good | Good | Good | Poor | Good | Good | Good |

From Tables 3 to 5, Examples 1 to 17 in which the polymers (A) A to G containing polysiloxane skeletons in both a diamine residue and an acid anhydride residue were used each provide a sheet having an elastic modulus of less than 100 MPa and a shear strain of 1.5 or more and having sufficient flexibility, adhesion to an adherend, and followability. In addition, the sheet has "good" heat resistance and can maintain a good adhesion state for a long period of time. In particular, in Examples 1 to 15 using the polymers (A) A to E containing 60 mol% or more of the diamine residue (1) in all diamine residues and 50 mol% or more of the acid anhydride residue (2) in all acid anhydride residues, the elastic modulus tends to be lower, and the shear strain tends to increase. By containing a large amount of the siloxane skeleton, the flexibility, the adhesion to an adherend, and the followability can be improved.

On the other hand, as can be seen from Table 5, Comparative Example 1 in which acrylic rubber was used as the thermoplastic resin had "poor" heat resistance, and the shear strain was significantly reduced by heating under vacuum at 250°C for 1,000 hours from an initial value of 4.12. In Comparative Example 2 in which an aromatic polyimide was used as the thermoplastic resin, the heat resistance was "good", but the elastic modulus was as very high as 4,500 MPa, and the shear strain was as very small as less than 0.5, so that flexibility, adhesion to an adherend, and followability were insufficient. In Comparative Example 3 in which the polymer (A) H containing a polysiloxane structure only in a diamine residue was used as the thermoplastic resin and Comparative Example 4 in which the polymer (A) I containing a polysiloxane structure only in an acid anhydride residue was used as the thermoplastic resin, the elastic modulus was reduced, and the shear strain was also increased as compared with Comparative Example 2. However, the elastic moduli were still as high as 110 MPa (Comparative Example 3) and 120 MPa (Comparative Example 4), the shear strain was less than 1.5, and flexibility, adhesion to an adherend, and followability are insufficient.

## Claims

1. A resin composition comprising:
a polymer (A) selected from a polyimide and a polyamic acid having a diamine residue represented by General Formula (1) (hereinafter referred to as a diamine residue (1)) and an acid anhydride residue represented by General Formula (2) (hereinafter referred to as an acid anhydride residue (2)); and
a thermosetting resin (B): 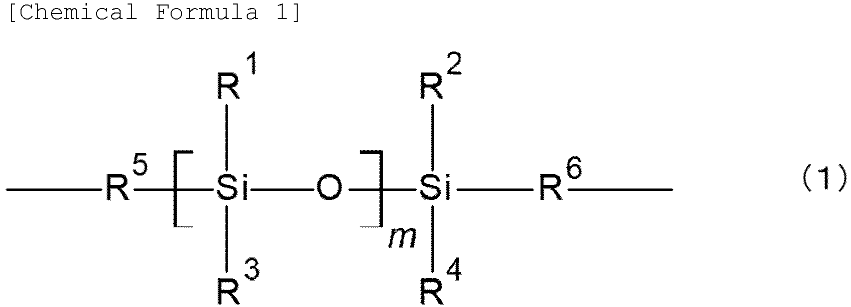
wherein, in General Formula (1), R¹ to R⁴ may be same or different and each represent an alkyl group having 1 to 30 carbon atoms, a phenyl group, or a phenoxy group, the phenyl group and the phenoxy group may be substituted with an alkyl group having 1 to 30 carbon atoms, m R¹s and R³s may be same or different,
in General Formula (1), R⁵ and R⁶ may be same or different and each represent an alkylene group having 1 to 30 carbon atoms or an arylene group, the arylene group may be substituted with an alkyl group having 1 to 30 carbon atoms,
in General Formula (1), m is an integer selected from 1 to 100, 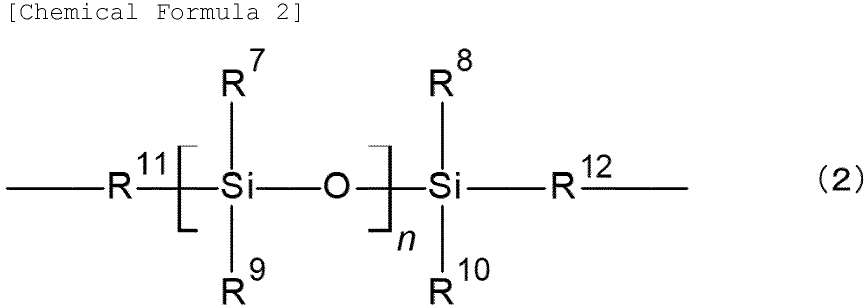
in General Formula (2), R⁷ to R¹⁰ may be same or different and each represent an alkyl group having 1 to 30 carbon atoms, a phenyl group, or a phenoxy group, the phenyl group and the phenoxy group may be substituted with an alkyl group having 1 to 30 carbon atoms, n R⁷s and R⁹s may be same or different,
in General Formula (2), R¹¹ and R¹² may be same or different and each represent an alkylene group having 1 to 30 carbon atoms or an arylene group, the arylene group may be substituted with an alkyl group having 1 to 30 carbon atoms, and
in General Formula (2), n is an integer selected from 1 to 100.

2. The resin composition according to claim 1, wherein a total of the diamine residue (1) and the acid anhydride residue (2) is 55 mol% or more and 100 mol% or less with a total of all diamine residues and all acid anhydride residues in the polymer (A) being 100 mol%.

3. The resin composition according to claim 1 or 2, containing 60 mol% or more and 100 mol% or less of the diamine residue (1) with all diamine residues in the polymer (A) being 100 mol%.

4. The resin composition according to any one of claims 1 to 3, containing 50 mol% or more and 100 mol% or less of the acid anhydride residue (2) with all acid anhydride residues in the polymer (A) being 100 mol%.

5. The resin composition according to any one of claims 1 to 4,
wherein the m is 3 or more and 40 or less, and
the n is 3 or more and 40 or less.

6. The resin composition according to any one of claims 1 to 5, wherein the polymer (A) has a glass transition temperature (Tg) of -150°C or higher and -30°C or lower.

7. The resin composition according to any one of claims 1 to 6, wherein the thermosetting resin (B) is at least one selected from the group consisting of a polyimide resin, a bismaleimide resin, an epoxy resin, a phenol resin, a urethane resin, a silicone resin, an acrylic resin, and a poly(amide-imide) resin.

8. The resin composition according to any one of claims 1 to 7, wherein the thermosetting resin (B) is at least one selected from the group consisting of an epoxy resin containing an aromatic skeleton, a flexible epoxy resin not containing a siloxane skeleton, and a crystalline epoxy resin.

9. The resin composition according to any one of claims 1 to 8, comprising an inorganic filler (C).

10. The resin composition according to any one of claims 1 to 9, comprising a curing agent or curing accelerator (D) .

11. The resin composition according to any one of claims 1 to 10, wherein a sheet cured product has a glass transition temperature (Tg) of -120°C or higher and 0°C or lower.

12. A sheet-form composition comprising the resin composition according to any one of claims 1 to 11 formed into a sheet.

13. A sheet cured product comprising a cured product of the resin composition according to any one of claims 1 to 11 or of the sheet-form composition according to claim 12.

14. A laminate comprising:
the resin composition according to any one of claims 1 to 11, the sheet-form composition according to claim 12, or the sheet cured product according to claim 13; and
a resin sheet.

15. A laminate member comprising in this order:
a member A;
the sheet cured product according to claim 13; and
a member B,
wherein linear expansion coefficients of the member A and the member B are different by one or more.

16. A wafer holder comprising the laminate member according to claim 15.

17. A semiconductor manufacturing device comprising the wafer holder according to claim 16.
